# EUROPEAN PATENT APPLICATION

(11) **EP 2 455 968 A1**
(43) Date of publication of application: **23.05.2012**
(21) Application number: 11190204.5
(22) Date of filing: 22.11.2011
(51) Int. Cl.: H01L 21/768, H01L 25/065

(54) **BATCH FABRICATED 3D INTERCONNECT**

(30) Priority: 23.11.2010 US 416485 P; 18.11.2011 US 299576
(71) Applicant: Honeywell International, Inc., Morristown, NJ 07962-2245 (US)
(72) Inventor: Horning, Robert D., Morristown, NJ 07962-2245 (US)
(74) Representative: Buckley, Guy Julian

(57) **Abstract**

In an example, a method of fabricating one or more vertical interconnects is provided. The method includes patterning and stacking a plurality of wafers to form a wafer stack. A plurality of apertures can be formed in the wafer stack within one or more saw streets of the wafer stack, and conductive material can be deposited on sidewalls of the plurality of apertures. The wafer stack can be diced along the one or more saw streets and through the plurality of apertures such that the conductive material on the sidewalls is exposed on an edge portion of resulting stacked dies

## Description

### CROSS-REFERENCE TO RELATED APPLICATIONS

This application claims the benefit of priority to U.S. Provisional Application No. 61/416,485, filed on November 23, 2010, the disclosure of which is incorporated herein by reference.

### BACKGROUND

Complex three-dimensional (3D) micro-electro-mechanical system (MEMS) chips can have electrical contacts on either the top and bottom surface, or both. Such a MEMS chip can include interconnects to couple a contact on one side (e.g., the top) of the chip to the other (e.g., the bottom), or even to a contact on an edge. These interconnects can be used to couple the MEMS chip to one circuit element on one side (e.g., couple the MEMS chip to a circuit board or package) and couple the MEMS chip to another circuit element (e.g., an ASIC) on another side. These interconnects can be created using through-wafer vias (TWVs). TWVs consume die area, which is not always available. Accordingly, the interconnects can also be created using screenprinting and direct write methods to directly print leads on the edges of a die. Printing leads on the edges of a die uses almost no extra die area, and edge leads are printed on one die at a time.

### SUMMARY

In an example, a method of fabricating one or more vertical interconnects is provided. The method includes patterning and stacking a plurality of wafers to form a wafer stack. A plurality of apertures can be formed in the wafer stack within one or more saw streets of the wafer stack, and conductive material can be deposited on sidewalls of the plurality of apertures. The wafer stack can be diced along the one or more saw streets and through the plurality of apertures such that the conductive material on the sidewalls is exposed on an edge portion of resulting stacked dies.

### DRAWINGS

Understanding that the drawings depict only exemplary embodiments and are not therefore to be considered limiting in scope, the exemplary embodiments will be described with additional specificity and detail through the use of the accompanying drawings, in which:

Figure 1 is a perspective view of an example three-dimensional chip having vertical interconnects on a plurality of edges.

Figure 2 is a flow diagram of an example method of batch fabricating the vertical interconnects of Figure 1.

Figures 3A-3E are perspective views of example stages within the method of Figure 2.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

The embodiments described below relate to a method of batch fabricating one or more vertical interconnects on one or more edges of a three-dimensional (3D) chip. In particular, the vertical interconnects can be fabricated at wafer-level. In an example, the vertical interconnects are formed by forming a plurality of apertures in one or more saw streets of a stack of wafers. Conductive material is then deposited on sidewalls of the plurality of apertures. The stack of wafers is then diced to split the plurality of apertures such that a portion of the vertically oriented conductive material in each aperture is on an edge of adjacent resulting stacked dies.

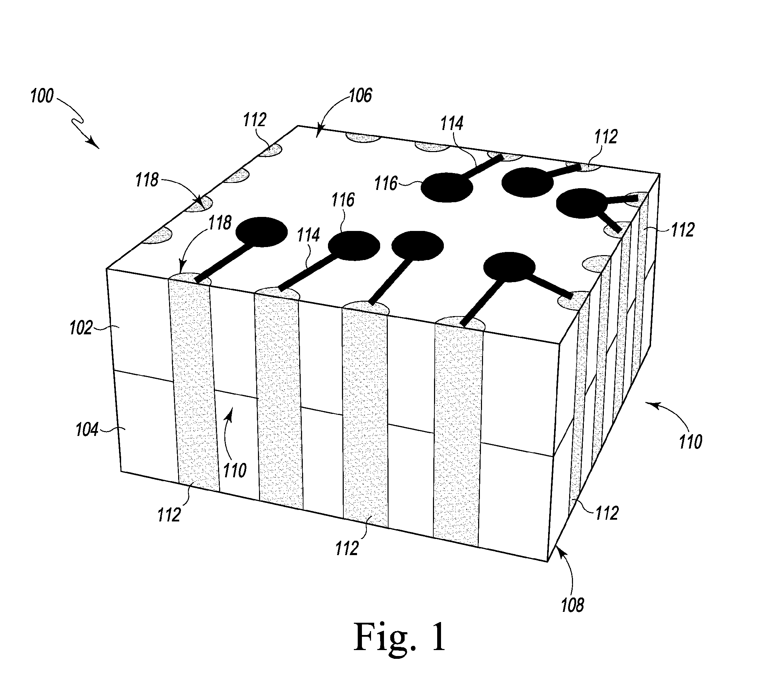

Figure 1 is a perspective view of an example 3D chip 100 having vertical interconnects on a plurality of edges. The chip 100 is composed of a plurality of layers stacked on top of one another. A layer comprises a die formed from a wafer. One or a combination of layers can include one or more micro-electro-mechanical system (MEMS) devices fabricated therein. In an example, the plurality of layers can include a plurality of MEMS gyroscopes and MEMS accelerometers therein, and the chip 100 comprises a MEMS internal measurement unit (IMU). In a specific example, the plurality of layers can include at least three MEMS gyroscopes oriented to sense three orthogonal axes of rotation and at least three MEMS accelerometers oriented to sense three orthogonal axes of acceleration. The substrate for a layer can be composed of any suitable MEMS fabrication material such as glass or silicon; moreover, some layers can be composed of a first material (e.g., glass) and other layers can be composed of a second material (e.g., silicon). For simplicity, the chip 100 is shown as including two layers: a first layer 102 and a second layer 104. It should be understood, however, that the chip 100 can include more than two layers. The plurality of layers 102, 104 are stacked on one another to form the stacked chip 100. Adjacent layers 102, 104 can be mounted to one another using any suitable die attach, such as bonding.

The chip 100 can include a plurality of sides including a top side 106, a bottom side 108, and a plurality of edges 110. The top side 106 and bottom side 108 are the sides that are oriented parallel to the conventional working planes or working surfaces of the wafers used to form the chip 100. The plurality of edges 110 are the sides that are oriented perpendicular to the top side 106 and the bottom side 108 and are thus oriented perpendicular to the conventional working planes or working surfaces of the wafers used to form the chip 100. It should be understood, however, that the chip 100 can be oriented in any manner and is not limited to the top side 106 being up and the bottom side 108 being down.

The chip 100 can include a plurality of interconnects 112 on one or more of the edges 110. An interconnect 112 can be oriented vertically (with respect to the conventional working planes or working surfaces of the wafers used to form the chip 100) and can be coupled to one or more traces 114 on the top side 106 and bottom side 108 of the chip 100. Accordingly, an interconnect 112 can electrically couple a trace 114 on the top side 106 of the chip 100 to a trace 114 on the bottom side 108 of the chip 100. In an example, the plurality of interconnects 112 are exposed on the edge 110 of the chip. In other examples, the plurality of interconnects 112 can be covered with a dielectric or other material. In some examples, a dielectric can be disposed between the interconnects 112 and the substrates of the layers 102, 104 to provide electrical isolation between the interconnects 112 and the substrates of layers 102, 104. The traces 114 can be coupled to a component fabricated in the chip 100 and/or to a pad (e.g., an input/output pad) for connecting the chip 100 to a mounting substrate such as a circuit board or application specific integrated circuit (ASIC). Accordingly, the pad can be configured to bond an ASIC and/or surface mount to a circuit board. Accordingly, as an example, a component in the first layer 102 of the chip 100 can be coupled to a pad on the bottom (e.g., opposite) surface 108 of the chip 100 using an interconnect 112. In another example, a component in the first layer 102 can be coupled to a component in the second layer 104 via an interconnect 112. The traces 114, and corresponding interconnects 112 can be coupled to one or more components in the chip 100 with a though substrate via (TSV) 116. In an example, an interconnect 112 extends from the top surface 106 to the bottom surface 108 of the chip 100. In an example, one or more interconnects 112 can be configured to connect to a circuit board and/or an ASIC. Accordingly, the chip 100 can be connected to a circuit board and/or an ASIC on an edge 110. This can enable the chip 100 to be mounted in different orientations.

An interconnect 112 can comprise a conductive material (e.g., a metal) disposed within a groove 118 in the edge 110 of the chip 100. The groove 118 can be formed in the substrate of each layer 102, 104 of the chip 100. In some examples, a dielectric material can be disposed in each groove 118 between the conductive material and the substrate. The dielectric material can be used to insulate the substrate and any conductive portions therein from the conductive material of the interconnect 112. Accordingly, the chip 100 can include a plurality of grooves 118 having conductive material forming a plurality of interconnects 112.

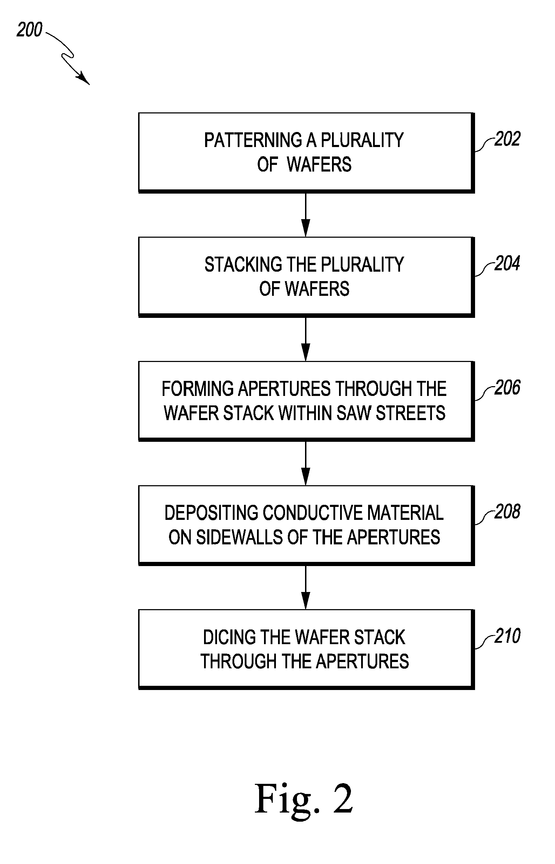

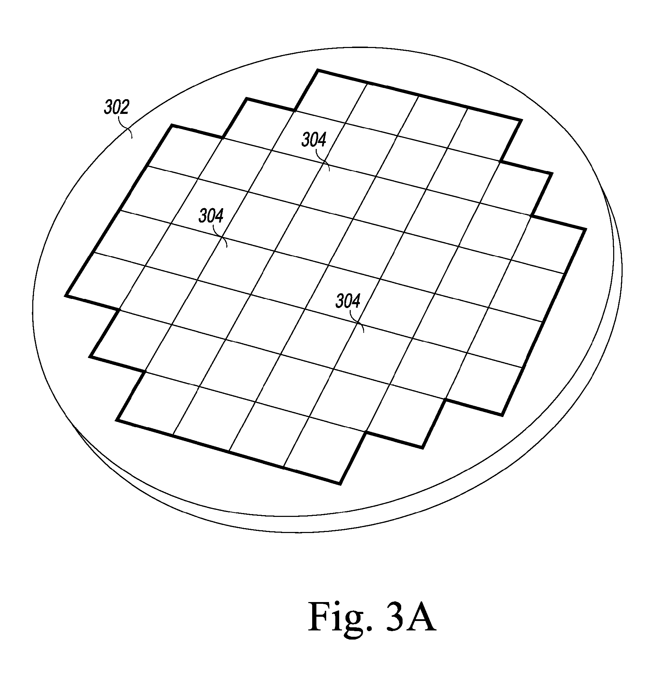

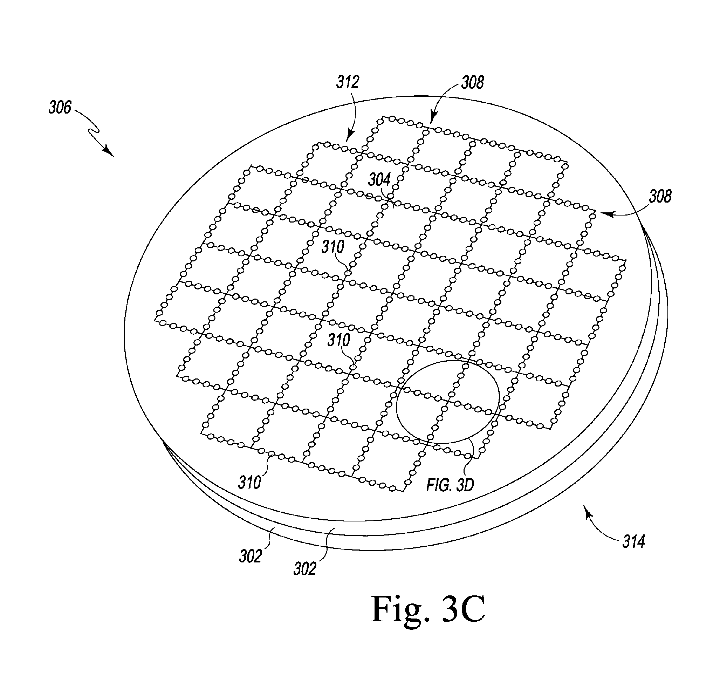

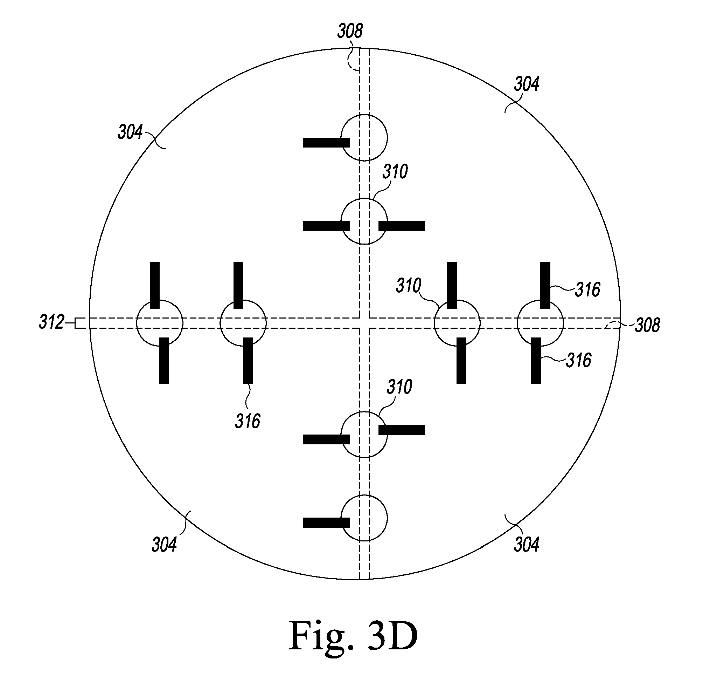

Figure 2 is a flow diagram of an example method 200 of forming vertical interconnects in a 3D chip 300 (Figure 3D). Figures 3A-3E are perspective views of example stages of the method 200.

The method 200 begins by patterning a plurality of wafers 302 with components (e.g., MEMS devices) to be included in the 3D chip (block 202 of Figure 2). Patterning can form a plurality of device areas 304 (e.g., undiced dies) on the conventional working planes or working surfaces of each wafer 302. Patterning can be accomplished using any suitable fabrication technique. In an example, the components on each device area 304 can include at least one gyroscope or at least one accelerometer. Although a single wafer 302 is shown in Figure 3A, a plurality of wafers 302 are patterned. The wafers 302 can be the same as, or different from one another. In an example, a first wafer 302 is different than the second wafer 302. The wafers 302, however, can be configured to be stacked on top of one another. Accordingly, in an example, the device areas 304 on the wafers 302 can be approximately the same size and can have electrical or mechanical structures configured to contact or engage with corresponding structures on another wafer 302.

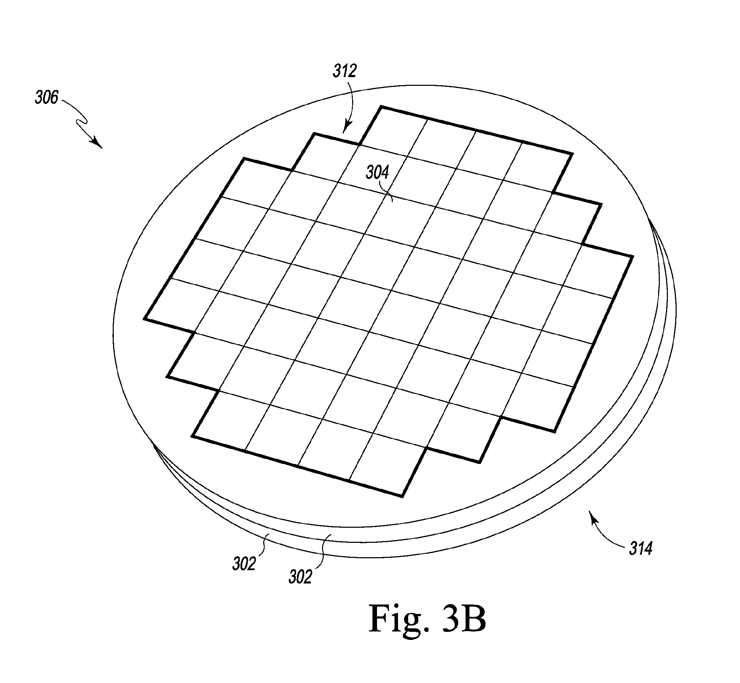

As shown in Figure 3B, the patterned wafers 302 can be stacked on top of one another to form a wafer stack 306 (block 204 of Figure 2). As shown, a first wafer 302 can be aligned with the second wafer 302 such that the device areas 304 of each wafer 302 are aligned. In particular, the device areas 304 of each wafer 302 can be aligned such that the wafer stack 306 can be diced between adjacent device areas 304 of each wafer 302 to form a plurality of stacked dies (e.g., chip 100). In an example, the first wafer 302 can be bonded to the second wafer 302 using a suitable bonding technique such as anodic bonding, solder bonding, or eutectic bonding. Although the wafer stack 306 shown in Figure 3B includes two wafers 302, in other examples, more than two wafers 302 can be used.

In an example, one or more traces (shown in Figure 3D at 316) can be patterned on the top surface 312 and/or bottom surface 314 of the wafer stack 306. These traces 316 can comprise conductive material and can electrically couple the device area 304 and/or a pad to the not yet formed interconnects. The one or more traces 316 can be patterned in any suitable manner and can be compose of any suitable material such as metal or polysilicon. Additionally, one or more pads (e.g., on the bottom surface 314) can be patterned in the same step or steps as the one or more traces 316. In an example, the one or more traces 316 are patterned prior to forming the apertures discussed below. In other examples, however, the one or more traces 316 can be patterned after forming the apertures or at any appropriate time.

The wafer stack 306 can include a plurality of saw streets 308 between adjacent device areas 304. The saw streets 308 can provide the space for dicing the wafer stack 306 into a plurality of stacked dies. A plurality of apertures 310 can be formed such that the apertures 310 are partially within the saw streets 308 (block 206 of Figure 2). These apertures can be formed prior to dicing the wafer stack 306. The apertures 310 can extend vertically (with respect to the conventional working planes or working surfaces of the wafers 302) through the wafer stack 306. The apertures 310 can extend from a top surface 312 of the wafer stack 306 to a bottom surface 314 of the wafer stack 306. Accordingly, the apertures 310 can extend all the way through the wafer stack 306. In an example, the apertures 310 are generally cylindrical in shape; however, the apertures 310 can be any suitable shape.

An aperture 310 can include one or more sidewalls. The one or more sidewalls can be composed of substrate of the wafers 302. Accordingly, in an example, the one or more sidewalls can be composed of glass. The apertures 310 can be formed using one of ultrasonic drilling, sandblasting, laser drilling, mechanical drilling, or etching; however, any suitable method of forming the apertures 310 can be used.

Figure 3D is a zoomed in view of the wafer stack 306. As shown, saw streets 308 can be defined between adjacent device areas 304 on the wafer stack 306. The apertures 310 can be formed such that a portion of the aperture 310 is within the saw streets 308. In an example, the apertures 310 can have a width 312 that is sufficient for a dicing operation to be performed while still leaving a portion of the aperture 310 on a resulting stacked die. That is, the width 312 can be larger than the saw street 308 such that the dicing operation does not eliminate the aperture 310 from a resulting stacked die. Width 312 corresponds to one or more directions that are perpendicular to the direction of the respective saw streets 308 (e.g., perpendicular to the sawing direction) and within the surface of the wafer stack 306. Since different saw streets 308 can be oriented in different directions on a wafer stack 306, the width 312 can have corresponding different directions. In an example, the apertures 310 are generally centered between the two adjacent device areas 304 on either side of the saw street 308. This can enable the dicing operation to split an aperture 310 into two portions, one on each of the resulting stacked dies.

Once the apertures 310 have been formed, the conductive material can be deposited on the sidewalls of the apertures 310 (block 208 of Figure 2). This conductive material is deposited prior to dicing the wafer stack 306. The conductive material can include metal, polysilicon, or other conductive materials. The conductive material can be deposited using any suitable technique including sputtering, chemical vapor deposition, plating, or a combination thereof. The conductive material can be deposited such that the conductive material forms an electrical path from the top surface 312 to the bottom surface 314 of the wafer stack 306. In an example, the conductive material can substantially fill the apertures 310.

In an example, a dielectric material can be deposited on the sidewalls of the apertures 310 prior to depositing the conductive material thereon. The dielectric material can insulate the substrates of the wafer stack 306 from the conductive material in the apertures 310, thereby reducing the likelihood of an unintended electrical coupling. Any suitable dielectric material can be used such as silicon dioxide (SiO2), polyimide, or parylene.

As mentioned above, one or more traces 316 can be formed on the top surface 312 and/or bottom surface 314. In an example, the one or more traces 316 and the conductive material in the apertures 310 can be deposited such that they are connected. That is, the conductive material in the apertures 310 can be connected to the one or more traces 316. The traces 316 can couple the conductive material in the apertures 310 to components in the device area 304 and/or to a pad (e.g., an input/output pad) for a resulting stacked die. In a particular example, the trace 316 on the top surface 312 can couple the conductive material in the aperture 310 to a through substrate via (TSV) which is electrically coupled to a component in of the device area 304. Additionally, a trace 316 on the bottom surface 314 can couple the conductive material in an aperture 310 to a pad for connection of the resulting stacked die to a mounting substrate (e.g., a circuit board). Accordingly, a component in a first wafer 302 can be coupled through a first trace 316 on the top surface 312 to a pad on the bottom surface 314 via conductive material in an aperture 310.

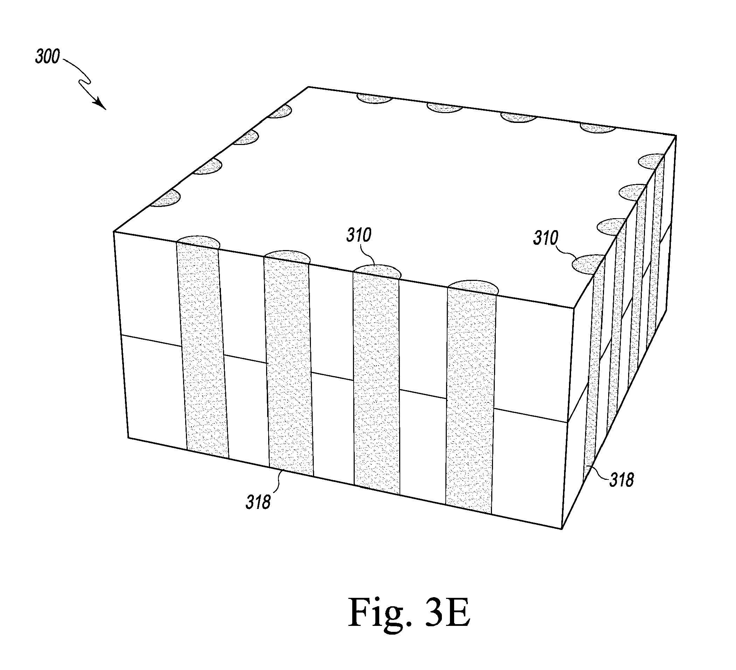

Once the conductive material has been deposited in the apertures 310, wafer stack 306 can be diced to form a plurality of stacked dies (block 210 of Figure 2). The wafer stack 306 can be diced along the saw streets 308 through the apertures 310 such that a portion of the conductive material of a given aperture 310 remains on an edge of the resulting stacked die. Due to the non-zero width of the saw used to dice the wafer stack 306, the dicing operation uses up a portion of material in the saw street as waste. Dicing through the apertures 310 causes some of the conductive material in the apertures 310 to be waste. Accordingly, in order to dice the wafer stack 306 such that a portion of the conductive material of a given aperture 310 remains on an edge of the resulting stacked die, the position and size of the apertures 310 with respect to the position of the dicing operation is controlled such that the dicing operation uses some of the conductive material in the apertures 310 as waste while leaving other portions on the resulting stacked dies. As shown in Figure 3E, the remaining portion of the conductive material 318 in the apertures 310 can be exposed on an edge of the resulting stacked die 300. In an example, dicing can include splitting the apertures 310 such that a first portion of the conductive material of a first aperture 310 is on a first stacked die and a second portion of the conductive material of the first aperture 310 is on a second stacked die. In an example, dicing can generally evenly split the first aperture 310 such that the first portion and the second portion are generally equal in size. The dicing operation can be performed in any suitable manner including sawing the wafer stack 306 with a saw blade.

Accordingly, vertical interconnects can be formed on an edge of a stacked die through batch processing at wafer-level. Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A method of fabricating one or more vertical interconnects (112), the method comprising:
patterning (202) a plurality of wafers (302);
stacking (204) the plurality of wafers (302) to form a wafer stack (306);
forming (206) a plurality of apertures (310) through the wafer stack (306) within one or more saw streets (308) of the wafer stack (306);
depositing (208) conductive material on sidewalls of the plurality of apertures (310); and
dicing (210) the wafer stack (306) along the one or more saw streets (308) and through the plurality of apertures (310) such that the conductive material on the sidewalls is exposed on an edge portion (110) of resulting stacked dies (100, 300).

2. The method of claim 1, comprising:
depositing a dielectric material on the sidewalls prior to depositing conductive material on the sidewalls.

3. The method of any of claims 1 or 2, wherein dicing (210) includes splitting the plurality of apertures (310) such that a first portion of the conductive material of a respective aperture (310) is on a first resulting stacked die (100, 300) and a second portion of the conductive material of the respective aperture (310) is on a second resulting stacked die (100, 300).

4. The method of any of claims 1-3, comprising:
patterning conductive traces (114) on a top (106) and bottom (108) surface of the wafer stack (306) such that the conductive traces (114) electrically couple the conductive material on the sidewalls with the conductive traces (114) on the top (106) and bottom (108) surface.

5. The method of any of claims 1-4, wherein patterning (202) includes forming at least one of a micro-electro-mechanical system (MEMS) gyroscope or a MEMS accelerometer in the plurality of wafers (302).

6. The method of any of claims 1-5, wherein stacking (204) the plurality of wafers (302) includes bonding adjacent wafers;
wherein forming (206) the plurality of apertures (310) includes one of ultrasonic drilling, sandblasting, laser drilling, mechanical drilling, or etching the wafer stack (306); and
wherein depositing a conductive material includes depositing a metal.

7. A three dimensional chip (100, 300) comprising:
a plurality of layers (102, 104) stacked on one another to form a stacked chip (100) having a top surface (106), a bottom surface (108), and a plurality of edges (110);
one or more grooves (118) defined in an edge (110) of the stacked chip (100), the one or more grooves (118) extending from the top surface (106) to the bottom surface (108);
conductive material in the one or more grooves (118);
a first one or more traces (114) on the top surface (106) of the stacked chip (100), the first one or more traces (114) electrically coupling the conductive material in the one or more grooves (118) to one or more components of the stacked chip (100); and
a second one or more traces on the bottom surface (108) of the stacked chip (100), the second one or more traces electrically coupled to the conductive material in the one or more grooves (118).

8. The three dimensional chip (100, 300) of claim 7, wherein the second one or more traces electrically couple the conductive material in the one or more grooves to one or more pads on the bottom surface (108) for connecting to a mounting substrate.

9. The three dimensional chip (100, 300) of any of claims 7 or 8, comprising:
a dielectric material in the one or more grooves (118) and disposed between the substrates of the stacked chip (100) and the conductive material.

10. The three dimensional chip (100, 300) of any of claims 7-9, wherein substrates of the plurality of layers (102, 104) are composed of one of glass or silicon; and
wherein the plurality of layers (102, 104) include a micro-electro-mechanical system (MEMS) gyroscope and a MEMS accelerometer fabricated therein.
